# EUROPEAN PATENT SPECIFICATION

(11) **EP 1 480 256 B1**
(45) Date of publication and mention of the grant of the patent: **27.09.2006**
(21) Application number: 04019624.8
(22) Date of filing: 19.02.1996
(51) Int. Cl.: H01L 21/00, B65D 25/10

(54) **Thin-plate supporting container**
Stützbehälter für dünne Scheiben
Conteneur support de plaques minces

(30) Priority: 26.06.1995 JP 15913695; 18.08.1995 JP 21055295; 18.08.1995 JP 21055395; 07.07.1995 JP 69159595 U
(43) Date of publication of application: 24.11.2004
(62) Divisional of application: 96102467.6
(73) Proprietor: Miraial Co., Ltd., Tokyo (JP)
(72) Inventor: Kakizaki, Takeyoshi, Toshima-ku Tokyo (JP); Hyobu, Yukihiro, Toshima-ku Tokyo (JP)
(74) Representative: Grünecker, Kinkeldey, Stockmair & Schwanhäusser Anwaltssozietät

(56) References cited:
- EP-A- 0 431 814
- EP-A- 0 520 105
- EP-A- 0 571 678
- EP-A- 0 579 099
- CA-A- 1 049 662
- US-A- 3 723 823
- US-A- 4 153 164
- US-A- 4 762 689
- US-A- 5 255 797
- PATENT ABSTRACTS OF JAPAN vol. 0080, no. 66 (E-234), 28 March 1984 (1984-03-28) -& JP 58 215052 A (NIPPON DENKI KK), 14 December 1983 (1983-12-14)

## Description

The present invention relates to a thin-plate supporting container according to the preamble part of the independent claim 1. The thin-plate supporting container is adapted for containing and supporting a plurality of thin plates such as semiconductor wafers on multiple stages spaced uniformly and for storing and transferring the thin plates, each of which is automatically loaded and unloaded by a robot or the like.

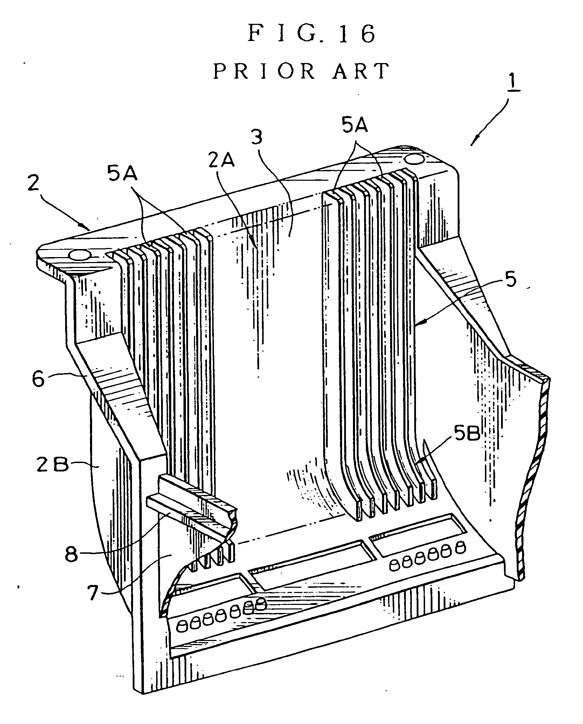

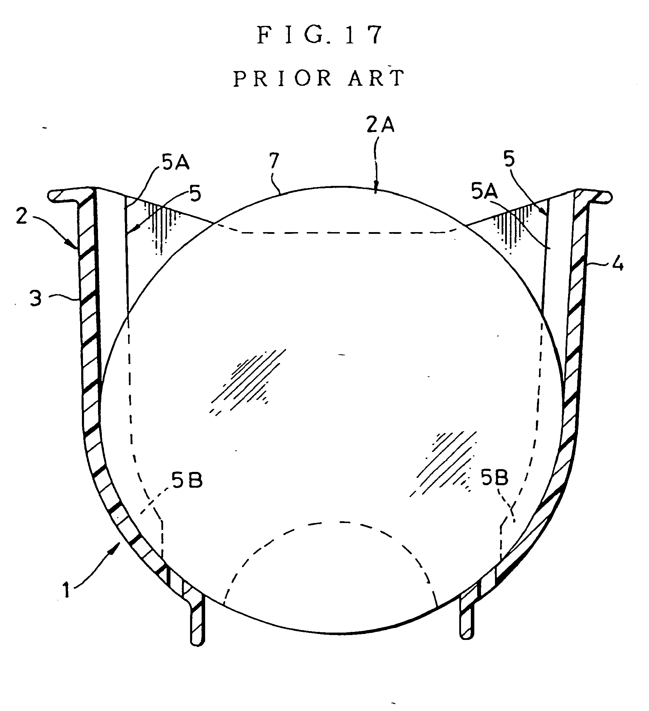

For example, a semiconductor wafer carrier, which uses semiconductor wafers as thin plates, has been known as a conventional thin-plate supporting container for simultaneously containing and supporting a plurality of thin plates and transporting the contained thin plates, each of which is automatically loaded and unloaded by a robot or the like. This conventional semiconductor wafer carrier will be described hereinbelow by referring to FIGS. 16 and 17. FIG. 16 is a partially cutaway perspective diagram for illustrating the inner structure of only one of a pair of opposed side walls of a semiconductor wafer carrier 1. FIG. 17 is a front sectional view of the semiconductor wafer carrier 1.

Roughly speaking, the semiconductor wafer carrier 1 consists of a casing 2, whose top is opened so as to form a wafer inlet/outlet opening 2A, through which a wafer is loaded thereinto and is unloaded therefrom, and supporting ribs 5 which are respectively formed on the two opposed inner side surfaces of the casing 2 and are operative to hold and support a multitude of wafers on multiple stages.

Each of the supporting rib portions 5 is composed of a multitude of rib pieces 5A formed in parallel on each of the side walls 3 and 4 at regular intervals. Further, each of the supporting rib pieces 5A is molded or formed in such a manner that the opening angle between the opposed side surfaces (namely, both of the vertical side surfaces) of each rib piece 5A, as well as the distance or interval between adjacent rib pieces 5A, is large and that the transverse sections of the rib pieces 5A arranged along the (lateral) length of casing 2 have a same shape.

Moreover, innermost-part supporting portions 5B molded by being inwardly bent in the casing 2 are provided in the innermost parts of the supporting rib portions 5, respectively, and are operative to place a limitation on how deep a wafer 7 can be inserted into the casing 2, and to put the wafer 7 in a particular position in the casing 2.

Furthermore, on a side end wall (namely, the left end wall of FIG. 16) of a left-side part 2B of the casing 2, there is provided a horizontal wafer supporting plate portion 6 for supporting the casing 2 in such a manner that the wafer 7 inserted thereinto is in an accurately horizontal position when this casing 2 is placed on a mounting base so that the longitudinal side extends vertically. As viewed in this figure, another horizontal wafer supporting plate portion, which is paired with the horizontal wafer supporting plate portion 6 of the left-side part 2B, is provided on the left end wall of a right-side part (not shown) of the casing 2 and extends along the vertical length (namely, the height) of the casing 2. Additionally, a connecting plate portion 7 for connecting the pair of the horizontal wafer supporting plates with each other is provided therebetween. On this connecting plate portion 7, a positioning ridge 8 is provided between the left-side and right-side parts of the casing 2 in such a way as to connect the pair of the horizontal wafer supporting plates with each other.

All of the casing 2, the side walls 3 and 4 and the supporting rib portions 5 are made of synthetic resin and are formed in such a manner as to be solid, namely, completely firm without any spaces or holes.

In the conventional semiconductor wafer carrier 1 having the aforementioned configuration, a plurality of wafers 7 are supported in parallel with each other and on multiple stages. The plurality of wafers 7 are carried and washed together with the wafer carrier 1.

Further, when a wafer 7 is loaded into and is unloaded from this semiconductor wafer carrier 1, this carrier 1 is mounted on the mounting base under a condition in which each of the horizontal supporting portions 6 is brought into an abutting engagement with the mounting base.

Meanwhile, in the case that a wafer 7 is loaded into and is unloaded from the carrier 1 by a fork or the like of a robot, the wafer carrier 1 should be positioned on the mounting base accurately.

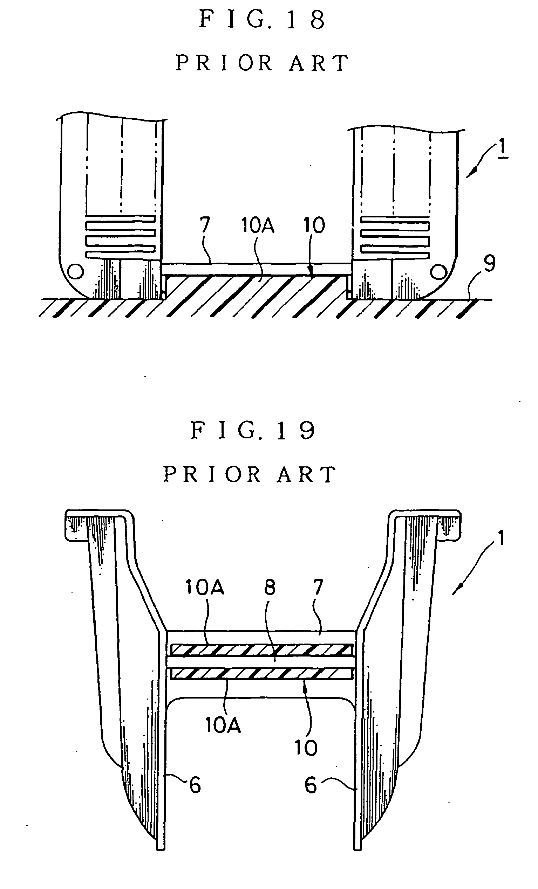

Thus, as illustrated in FIGS. 18 and 19, hitherto, the horizontal positioning of the wafer carrier 1 is performed by using the positioning ridge 8 under a condition in which the vertical positioning of the wafer carrier 1 is performed by bringing the horizontal wafer supporting portions 6 in abutting engagement with the upper side surfaces of the mounting base 9. Namely, a positioning fit portion 10 consisting of two ridges 10A provided in such a manner as to support the positioning ridge 8 from both sides thereof, respectively, is formed the mounting base 9. The positioning of the wafer carrier 1 is performed by fitting the positioning ridge 8 into a space between the two ridges 10A of the positioning fit portion 10 under a condition in which the horizontal wafer supporting plate portions 6 are brought into abutting engagement with the surface of the mounting base 9.

Thereby, the positioning of the wafers 7, which are respectively contained into multiple slots of the stages, in the horizontal and vertical directions with respect to the fork of the robot can be accurately achieved.

Further, the wafer 7 is automatically loaded thereinto and unloaded therefrom by this fork of the robot. Namely, the fork of the robot is accurately inserted into a gap between adjoining ones of the wafers 7 supported vertically in the wafer carrier 1 and then lifts the upper one of the adjoining wafers 7 slightly and subsequently unload the lifted wafer from the wafer carrier 1. Thereafter, the wafer supported by the fork is accurately inserted into the innermost position between adjacent ones of the multitude of the rib pieces 5A. Then, the fork is lowered slightly so that this wafer 7 comes to be supported by the rib pieces 5A.

Meanwhile, the aforementioned semiconductor wafer carrier 1 is formed in such a way that the opening angle between the opposed side surfaces (namely, the vertically extending side surfaces) of each rib piece 5A is large so as to facilitate load and unload the wafer 7.

On the other hand, if a shock such as a vibration is given to the wafer carrier 1 from the outside during carrying the wafer by using the wafer carrier 1, the wafer 7 is sometimes out of place in the wafer carrier 1. Further, when the wafer 7 is laterally dislocated in the wafer carrier 1, the wafer 7 become inclined greatly from horizontal, because the angle of inclination of the upper side surface of each of the rib pieces 5A is large. As a result, when the robot automatically loads and unloads a wafer, the fork of the robot comes in contact with the wafer 7 and further the wafer 7 is also brought into contact with the rib piece 5A. Thus, the aforementioned wafer carrier has drawbacks in that there are possibilities of damage to the wafer 7 and of generation of dusts.

Further, if a shock such as a vibration to be given to the wafer carrier 1 is large, the wafer 7 is out of place largely. When things come to the worst, the wafer 7 may slide down the wafer carrier 1.

Moreover, in the case of the aforesaid semiconductor wafer carrier 1, a thick portion of the wafer carrier 1 is different in the coefficient of heat contraction or shrinkage from a thin portion thereof and a sink or the like is sometimes caused because all of the casing 2, the side walls 3 and 4 and the supporting rib portions 5 are made of solid synthetic resin as described above. Furthermore, when this sink or shrinkage is caused, an error or change in accuracy of dimension occurs, with the result that the wafer 7 cannot be maintained in a horizontal position and is some-times put in an inclined state or position. In this case, similarly as in the aforementioned case, when a wafer is automatically loaded or unloaded by the robot, there are possibilities of damage to the wafer 7 and of generation of dusts.

Furthermore, when positioning the wafer carrier 1 by means of the positioning ridge 8 and the positioning fit portion 10, no problem arises in the case that the wafer 7 has a small diameter, namely, in the case that the wafer carrier 1 is of small size. In such a case, the positioning of this wafer carrier 1 can be achieved accurately to some extent by means of the positioning ridge 8 and the positioning fit portion 10. Thus the positioning of each of the wafers 7 with respect to the fork of the robot can also be achieved accurately.

However, in the case that the diameter of the wafer 7 is increased and thus the wafer carrier 1 is of large size, the positioning of the wafer carrier 1 cannot be achieved accurately by means of the positioning means having a simple configuration, which consists of the positioning ridge 8 and the positioning fit portion 10. Consequently, the problems of damage to the wafer and of the generation of dusts may arise.

From EP-A-0 579 099 a thin-plate supporting container as indicated is known, wherein the container comprises a movable stopper element and a movable receiver element for preventing displacement of the wafer carriers.

It is an objective of the present invention to improve a thin-plate supporting container as indicated above.

The objective is solved according to the present invention by a thin-plate supporting container comprising a casing having side walls; supporting rib portions, each of which consists of multiple rib pieces, for supporting thin plates respectively on multiple stages at regular intervals, the supporting rib portions being provided on each of the side walls of the container in parallel in such a way that each of the supporting rib portions provided on one of the side walls and a corresponding each of the supporting rib portions provided on the other of the side walls face each other and sandwich the thin plate when supported in the container, and an opening portion serving as an inlet/outlet port, through which the thin plate is loaded or unloaded from the container, wherein each of the rib pieces has a thin-plate supporting portion, wherein the thin-plate supporting portion is provided on one of the outer surfaces of each of the rib pieces and comprises a horizontally-supporting-part and a shift preventing surface part, the horizontally-supporting-portion having a supporting surface which extends horizontally so as to be able to support a thin plate horizontally when the container is oriented such that the rib portions extend horizontally, and the shift preventing surface part comprising a wall surface formed in the form of an arc conformal in shape to the peripheral edge of a thin plate for coming into abutting engagement with the periphery edge of a thin plate supported by the horizontally-supporting-part so as to prevent the thin plate from shifting toward the inlet/outlet port.

It is an advantage that the thin plate can be positioned accurately and can be supported in a horizontal position accurately to thereby prevent the thin-plate from coming into contact therewith, and further the thin plate can surely prevented from being out of place owing to an external shock such as a vibration.

Further preferred embodiments of the present invention are laid down in the further subclaims.

In the following, the present invention is explained in greater detail by means of several embodiments thereof in conjunction with the accompanying drawings, wherein:
FIG. 1 is a sectional view of a primary part of the supporting rib portions of the matching portion of a first wafer carrier;
FIG. 2 is a sectional view of a primary part of the supporting rib portions of the inlet portion of the first wafer carrier;
FIG. 3 is a partially cutaway view of the first wafer carrier;
FIG. 4 is a sectional view of a primary part of a second wafer carrier, for illustrating a state thereof in which a wafer is put on the rib piece of each of the supporting rib portions;
FIG. 5 is a plan sectional view of the second wafer carrier as shown on FIG. 4;
FIG. 6 is a sectional view of a primary portion of an example of the supporting rib portion having a hollow structure;
FIG. 7 is a perspective diagram for illustrating a state of the second wafer carrier, which is contained in a carrier box;
FIG. 8 is a sectional view of a primary portion of a third wafer carrier embodying the present invention, in which a wafer is put on the thin plate supporting portion thereof;
FIG. 9 is a plan sectional view of the third wafer carrier as shown in FIG. 8;
FIG. 10 is a sectional view of a modification of the third wafer carrier;
FIG. 11 is a plan view of a fourth wafer carrier;
FIG. 12 is a plan view of a mounting base, on which the fourth wafer carrier is put;
FIG. 13 is a sectional view taken on line III-III indicated by arrows in FIG. 12;
FIG. 14 is a side sectional view of the fourth wafer carrier, in which a wafer carrier positioning concave portion is fit onto a positioning pin;
FIG. 15 is an enlarged view of a primary part of the carrier of FIG. 14;
FIG. 16 is a partially cutaway view of the conventional wafer carrier;
FIG. 17 is a plan sectional view of the conventional wafer carrier;
FIG. 18 is a side view of the conventional wafer carrier positioned on a mounting base; and
FIG. 19 is a plan view of the conventional wafer carrier of FIG. 18.

Hereinafter, the preferred embodiments of the present invention will be described in detail by referring to the accompanying drawings. Incidentally, the thin-plate supporting containers embodying the present invention are containers, each of which supports a plurality of parallel thin plates such as semiconductor wafers, storage disks and liquid crystal plates. Hereinafter, examples of employing a thin plate and a thin-plate supporting container as a semiconductor wafer and a semiconductor wafer carrier, respectively, are described.

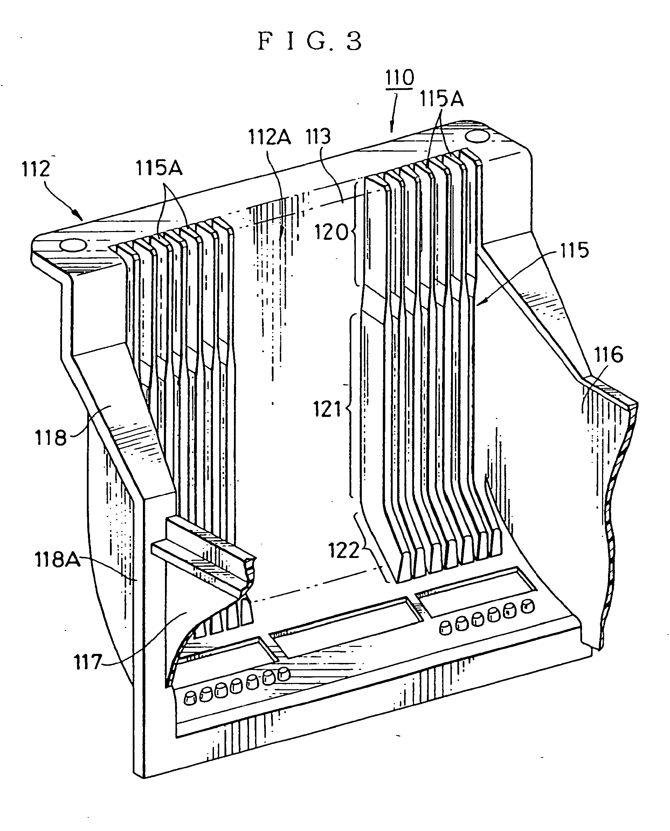

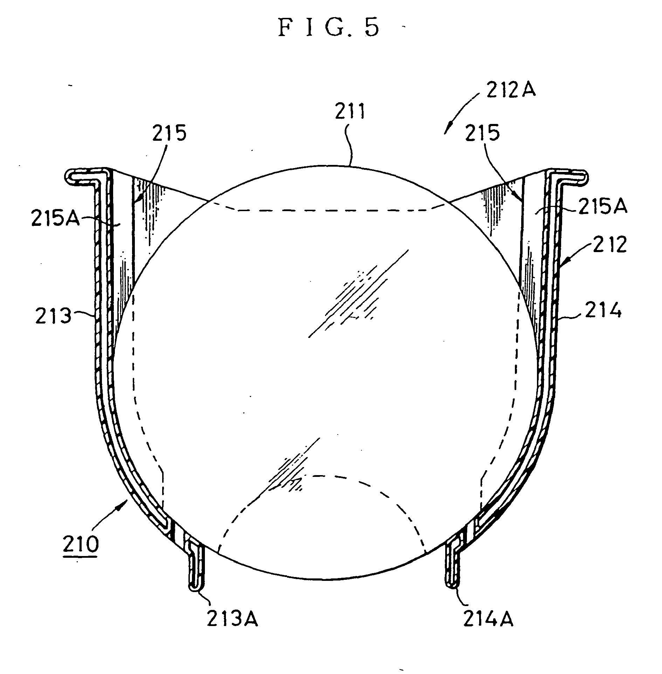

The entire configuration of a semiconductor wafer carrier 110 is almost similar to the aforementioned conventional semiconductor wafer carrier 1. Practically, as illustrated in FIG. 3, the semiconductor wafer carrier 110 consists of a casing 112, whose top is opened so as to form a wafer inlet/outlet port 112A, through which a wafer 211 (see FIG. 5) is loaded thereinto and is unloaded therefrom, and supporting rib portions 115 which are respectively formed on the two opposed side walls 113 (incidentally, only one of the side walls 113 is shown in FIG. 3 for simplicity of drawing) of the casing 112 and are operative to hold and support a plurality of wafers 211 in parallel on multiple stages.

The two opposed side walls 113 of the casing 112 are connected with each other and are supported by an upper end wall 116 and a lower end wall 117. This casing 112 is placed so that the longitudinal side extends vertically with the lower end wall 117 downward. Further, a horizontal wafer supporting plate portion 118 composing a reference surface 118A, which is used for supporting the casing 112 in such a manner that the wafer 211 supported therein is in a horizontal position when the casing 112 is placed so that the longitudinal side extends vertically, is provided on a side of each of the side walls 113 (namely, the left side of each of the side walls as viewed in FIG. 3). The wafer inlet/outlet port 112A is an opening, through which a wafer 211 is loaded and unloaded, and has a size set as being a little larger than the maximum size in the direction of a diameter of a disk-like wafer 211. It is the same with the distance between the two side walls 113.

The supporting rib portion 115 is composed of a multitude of rib pieces 5A formed in parallel on the inner surface of each of the side walls 113 at regular intervals. Further, each of the supporting rib portions 115 consists of an inlet portion 120 placed at the inlet/outlet-port-side thereof, a matching portion placed at an inner part thereof and an inner-part supporting portion 122 which is provided in the innermost parts thereof and are operative to place a limitation on how deep a wafer 211 can be inserted into the casing 112, and to support the wafer 211 from the inner side of the casing 112.

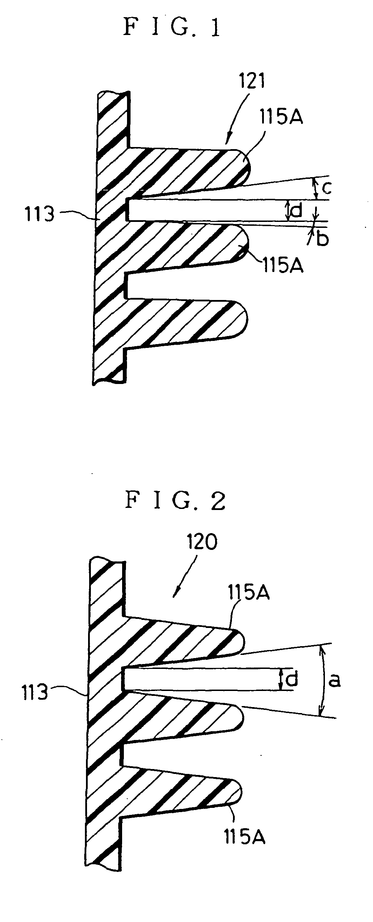

As illustrated in FIG. 2, the rib pieces 115A are formed so that the opening angle a between opposed side surfaces of each of the rib pieces 115A placed at the inlet portion 120 is large. This aims at facilitating the loading and unloading of the wafer 211.

Practically, the opening angles are set at the following numerical values correspondingly to a 6-inch (1 inch=2.54 cm) diameter wafer and an 8-inch diameter wafer 211, respectively.

An angle between a side surface of the rib piece 115A (namely, the lower side surface thereof illustrated in FIG. 2 in a state, in which the semiconductor wafer carrier 110 is placed so that the longitudinal side of the carrier 110 extends vertically, and in which the wafer 211 is supported in a horizontal position) and the horizontal is set at 7 degrees. Similarly, an angle between the other side surface of the rib piece 115A (namely, the upper side surface thereof illustrated in FIG. 2) and the horizontal is set at 7 degrees. Thereby, the opening angle between the opposed side surfaces of each rib piece 115A is set at 14 degrees.

As shown in FIG. 1, the upper side surface, on which the wafer 211 is put, of each of the rib pieces 115A placed at the matching portion 121 is formed in such a manner that the angle of inclination thereof is smaller than the angle of inclination of the upper side surface of the rib piece placed at the inlet portion 120. Practically, the angle of inclination of the upper side surface of each of the rib pieces 115A is set at an angle nearly equal to zero, namely, the upper side surface of each of the rib pieces 115A is dose to the horizontal. This setting is performed so that the wafer 211 can be accurately supported in a horizontal position during placed on each of the rib pieces 115A, that the wafer 211 can be maintained nearly in a horizontal position even when the wafer is laterally shifted only a little distance, and that both of side end portions of the wafer 211 put on the upper side surface of each of the rib pieces 115A come into point-contact or line-contact with the upper side surface thereof by inclining the upper side surface of each of the rib pieces a little to the horizontal.

Practically, the angle of inclination of the upper side surface of the rib piece is set at the following values correspondingly to the wafers 211, whose diameters are 6 inches and 8 inches.

The angle b between the upper side surface of the rib piece 115A and the horizontal is 1 degree. This angle is suitably set at a value in the range of 0.5 to 2.0 degrees or so in accordance with the size of the wafer 211. Further, the angle c between the lower side surface of the rib piece 115A is set at 7 degrees, with the Intention of facilitating the loading and unloading of the wafer 211 to and from this portion.

Incidentally, the width d (see FIG. 2) of a base portion between each pair of the adjacent rib pieces 115A of the inlet portion 120 is equal to that of a base portion between each of a part of the adjacent rib pieces 115A of the matching portion 121. These base portions are different from each other only in angle of inclination.

When the wafer 211 is inserted into the semiconductor wafer carrier 110 configured as above described, this wafer 211 is supported in a horizontal position by the fork (not shown) of a robot. Then, this wafer 211 is moved to an inserting place. Subsequently, the wafer 211 is inserted therefrom into the wafer carrier 110. At that time, the height of the inserting place is regulated in such a manner that a maximum-outside-diameter part of the wafer 211 (namely, a part having a maximum dimension in the lateral direction perpendicular to the two side walls 113) does not come into contact with the rib piece 115A of the matching portion 121, namely, in such a way that when inserting the wafer 211 into the carrier 110, this wafer 211 does not come into contact with the rib piece 115A.

During keeping the wafer 211 in this position, the wafer 211 is inserted into the wafer carrier 110 until the wafer 211 is in abutting engagement with the inner part supporting portion 122. When inserted thereinto, the wafer 211 can be easily inserted in the inlet portion 120 owing to the large opening angle a of the rib piece 115A of this inlet portion 120. Thereafter, the wafer 211 is carefully inserted into the matching portion 121 until the wafer 211 becomes in abutting engagement with the inner-part supporting portion 122. Subsequently, the fork of the robot goes down slightly and thus the wafer 211 is placed on the rib piece 115A of the matching portion 121. In this state, the wafer 211 is supported at four points on the inner-part supporting portion 122 and the matching portion 121 and is maintained in a horizontal position. Namely, the upper side surface of the rib piece 115A of the matching portion 121 is in a nearly horizontal position (the angle b is set at 1 degree). Thus, even when the wafer 211 placed on the upper side surface of this rib piece 115A is shifted laterally, this wafer 211 can be maintained in a nearly horizontal position. Thereby, the dimension of a gap between adjacent ones of the multiple wafers 211 stacked in the wafer carrier 110 becomes uniform.

When unloading (namely, taking out) one of the wafers 211 stored on multiple stages in the wafer carrier 110, the fork of the robot is inserted into the gap between the adjoining wafers 211. At that time, each of the wafers 211 is supported thereon in a horizontal position. The dimension of the gap between the adjoining wafers 211 is almost uniform. Thus the fork does not touch the wafer 211. When the fork is inserted to an inner part of the carrier 110, the fork moves slightly upwardly and lifts the wafer 211. Then, the fork is pulled out to the outside of the wafer carrier 110 and thus the wafer 211 is unloaded therefrom. At that time, the amount of upward shift of the wafer 211 caused by the fork is set at a value which is small to such an extent that the maximum-outside-diameter portion of the wafer 211 does not touch the lower side surface of the rib piece 115A of the matching portion 121.

As described above, in the aforesaid semiconductor wafer carrier 110, the wafer 211 can be supported on the upper side surface of the rib piece 115A of the matching portion 121 accurately in a horizontal position. Thus, when the wafer 211 is loaded and unloaded, a contact between the wafer and each of various portions of the carrier 110 can be prevented reliably. Thereby, the generation of dusts can be prevented.

Further, when inserting the fork into the casing 112, the fork is prevented from touching the wafer 211. Consequently, an occurrence of damage to the wafer, as well as an halt of a work line, can be prevented reliably.

Moreover, the upper side surface of the rib piece 115A of the matching portion 121 is slightly inclined to the horizontal. Thus, the wafer 211 comes into point-contact or line-contact with the upper side surface of the rib piece 115A. Consequently, a contact area therebetween can be minimized.

The entire configuration of a semiconductor wafer carrier 210 is almost similar to that of the aforementioned semiconductor wafer carrier 110. Practically, as illustrated in FIG. 5, the semiconductor wafer carrier 210 consists of a casing 212, whose top is opened so as to form a wafer inlet/outlet port 212A, through which a wafer 211 is loaded thereinto and is unloaded therefrom, and supporting rib portions 215 which are respectively formed on the two opposed side walls 213 and 214 of the casing 212 and are operative to hold and support a multitude of wafers 211 in parallel on multiple stages.

The casing 212 consists of the two opposed side walls 213 and 214 and end walls (not shown) for connecting the side walls 213 and 214 with each other at the upper and lower ends (namely, at the front and rear end portions illustrated in this figure). The interval between the side walls 213 and 214 is set at a dimension which is a little larger than the maximum diameter of the disk-like wafer 211.

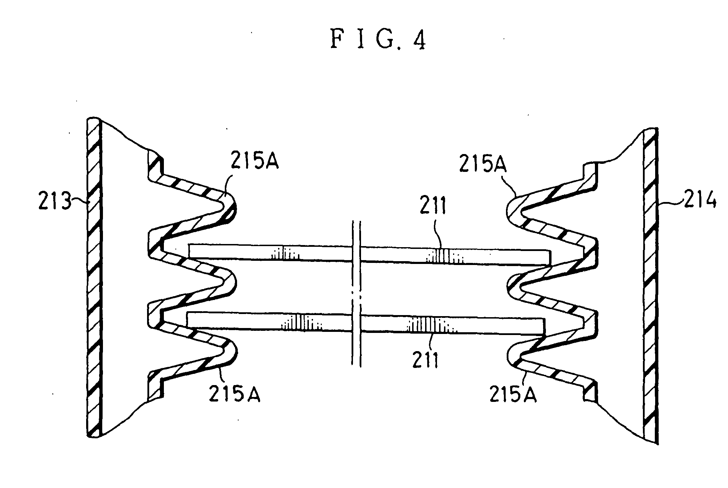

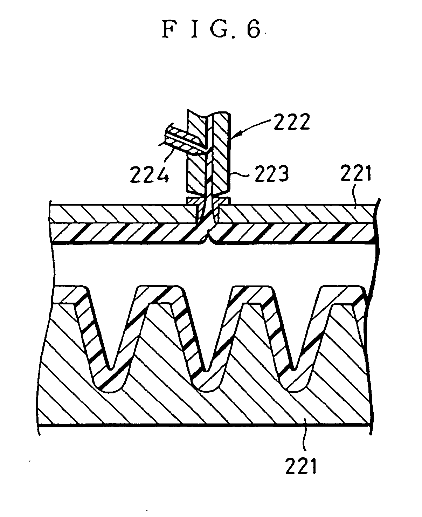

The supporting rib portion 215 is composed of a multitude of rib pieces 215A formed in parallel on the inner surface of each of the side walls 213 and 214 at regular intervals. Further, as illustrated in FIG. 4, the entire supporting rib 215, which includes the rib pieces 215A, has a hollow structure consisting only of shells. This hollow supporting ribs 215 are molded as follows. Namely, as illustrated in FIG. 6, the molding of the supporting ribs 215 is performed by using, for example, an injection molding machine provided with what is called a gas assistance device of the known type. First, a nozzle 222 is connected to a mold 221. Further, a synthetic resin is injected thereinto from a resin nozzle portion 223 of this nozzle 222. Moreover, gas or gas generating liquid is injected thereinto from a gas nozzle portion 224. Thereby, the synthetic resin is pressed by the gas in the mold 221 against the inner walls thereof. Consequently, the hollow structure consisting only of shells is completed.

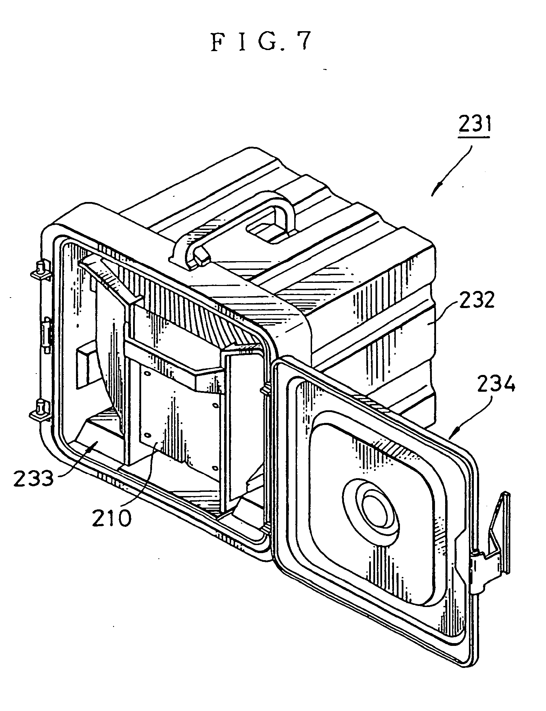

The wafer carrier 210 having the aforementioned configuration is sometimes enclosed in a carrier box 231, as illustrated in FIG. 7.

This carrier box 231 is composed mainly of a casing 232, which is formed by opening an end thereof and is used to contain the wafer carrier 210, and a lid 234 for blocking an opening portion 233 of the casing 232.

The wafer carriers 210 are contained in this carrier box 231. Thereafter, the wafer carriers 210 are s-forced therein and are transported by being contained therein.

Further, the wafer 211 is automatically loaded or unloaded by the robot (not shown) under a condition in which the wafer carrier 210 is placed so that the longitudinal side thereof extends vertically and thus the wafer 211 is supported in a horizontal position.

As described above, the supporting ribs 215 have a hollow structure. Thus, even in the case of an uneven portion such as the rib piece 215A, the thickness thereof can be nearly uniform. Thereby, the coefficient of heat contraction upon molding of the rib pieces and so on can be almost constant. Consequently, the accuracy of dimension of the rib piece or the like can be improved considerably.

As a result of using the rib pieces 215A with high accuracy of dimension, when loading and unloading the wafer 211 by using the robot, the wafer 211 is prevented from coming into contact with the rib piece 215A and with the robot. Thus the loading and unloading of the wafer 211 can be facilitated.

Further, it has been known that generally, a hollow structure results in increase in strength of the rib pieces. The high accuracy of dimension of this rib piece 215A can be maintained owing to the increase in strength of the rib pieces 215A.

Moreover, owing to the increase in strength of the rib pieces, mounting support portions 213A and 214A of the side walls 213 and 214 can be prevented from opening. Furthermore, the side walls 213 and 214 can be prevented from warping.

Additionally, the weight of the semiconductor wafer carrier 210 can be reduced.

Incidentally, each of the side walls 213 and 214 and the supporting rib portion 215 has a hollow structure. In addition to these portions, other portions of the wafer carrier may have a hollow structure.

Further, in addition to the semiconductor wafer carrier 210, the carrier box 231 may have a hollow structure. Thereby, the modifications can have similar effects.

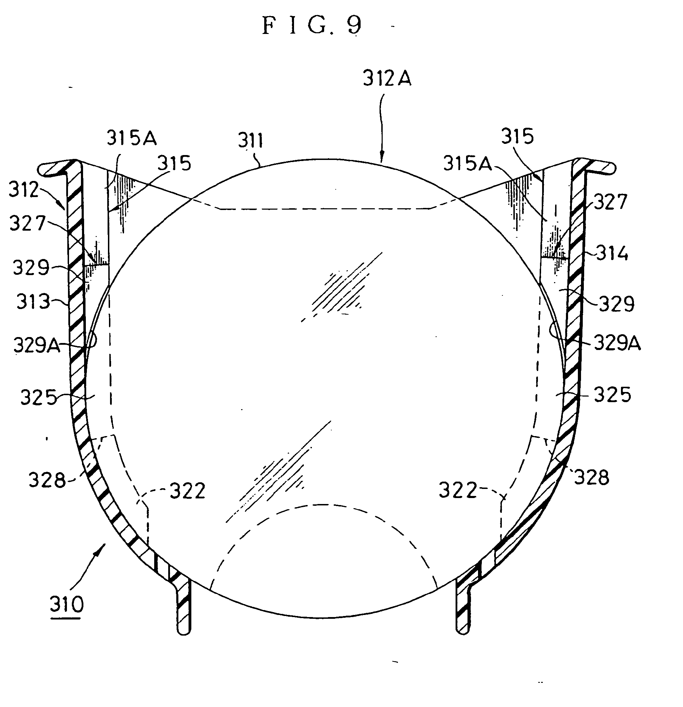

The entire configuration of a semiconductor wafer carrier 310 forming an embodiment of the present invention is almost similar to that of the first mentioned semiconductor wafer carrier 110 described above and is illustrated in FIG. 9. The semiconductor wafer carrier 310 consists of a casing 312, whose top is opened so as to form a wafer inlet/outlet port 312A, through which a wafer 311 is loaded thereinto and is unloaded therefrom, and supporting rib portions 315 which are respectively formed on the two opposed side walls 313 and 314 of the casing 312 and are operative to hold and support a multitude of wafers 311 in parallel on multiple stages.

The casing 312 consists of the two opposed side walls 313 and 314 and end walls (not shown) for connecting the side walls 313 and 314 with each other at the upper and lower ends (namely, at the front and rear end portions illustrated in this figure). The interval between the sidewalls 313 and 314 1 s set at a dimension which is a little larger than the maximum diameter of the disk-like wafer 311.

The supporting rib portion 315 is composed of a multitude of rib pieces 315A formed in parallel on the inner surface of each of the side walls 313 and 314 at regular intervals. Each of the rib piece 315A is formed in such a manner as to become thin throughout length thereof so that the distance between the adjacent rib pieces 315A is increased, thereby facilitating the loading and unloading of the wafer 311. When inserted into a space between the rib pieces 315A, the wafer 311 is supported at four points, namely, maximum diameter points 325 and 325 (to be described later) and two points on inner-part supporting portions 322 and 322. Here, note that the maximum diameter points 325 and 325 are points where a line passing through the center of gravity of the wafer 311 inserted into the wafer carrier 310 and extending perpendicular to the direction, in which the wafer 311 is loaded and unloaded, intersects with the supporting ribs 315.

On the upper side surface of the rib piece 315A, there is provided a thin-plate supporting portion 327 for supporting the wafer 311 in a horizontal position. The thin-plate supporting portions 327 having a fixed width are provided on the rib pieces 315A in front of and in rear of the maximum-diameter-points 325 and 325 in such a way as to put the points 325 therebetween. The wafer 311 is supported at four points on the two thin-plate supporting portions 327 and the inner-part portions 322. The size or width of the thin-plate supporting portion 327 may be small (namely, the thin-plate supporting portion may have a narrow width in the longitudinal direction of the rib piece 315A), because of the fact that the size of the thin plate supporting portion 327 is sufficient as long as the wafer 311 can be supported on the neighboring regions of the maximum-diameter points 325 and 325. Moreover, it is apparent that the width of the thin-plate supporting portion may be large to some extent.

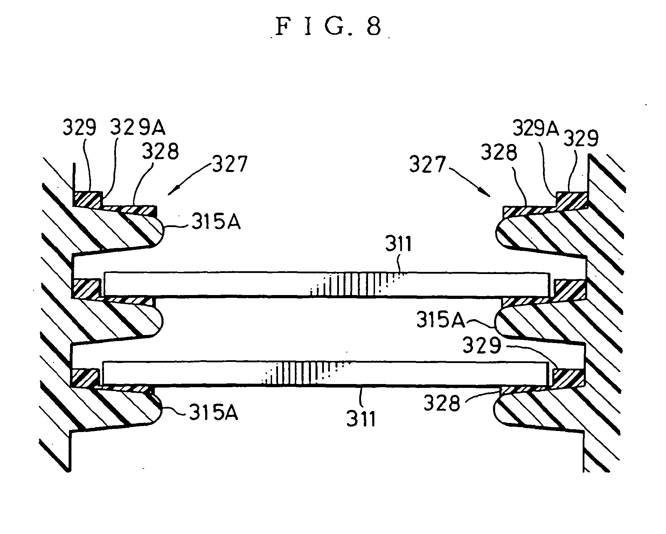

As shown in FIGS. 8 and 9, each of the thin-plate supporting portions 327 consists of a horizontally-supporting-plate part 328 and a shift preventing surface part 329 and is formed like a staircase. The horizontally-supporting-plate part 328 is provided in such a manner as to include the maximum-diameter-points 325 and 325 and extend in the longitudinal direction of the rib piece 315A. The upper side surface of the horizontally-supporting-plate part 328 is provided in such a way as to be accurately in a horizontal position when the wafer carrier 310 is placed so that the longitudinal side thereof extends vertically. The wafer 311 inserted into the wafer carrier 310 is supported and maintained in a horizontal position by bringing the lower edge surface thereof into abutting engagement with the upper side surface of the horizontally-supporting-plate part 328 and by being placed on the upper side surface of the portion 328.

The shift preventing surface part 329 is placed in front of the horizontally-supporting-plate part 328 of the rib piece 315A (namely, at the side of the wafer inlet/outlet port 312A). This shift preventing surface part 329 has a wall surface 329A which is formed by being elevated like an arc along the peripheral edge of the wafer 311 placed on the horizontally-supporting-plate part 328. The arcuately elevated wall surface 329A is brought directly into the front edge portion of the wafer 311 supported by the horizontally-supporting-plate part 328 in a horizontal position. Thereby, the shift preventing surface part 329 prevents an occurrence of a shift in position of the wafer 311. Namely, the wafer 311 is reliably prevented by the shift preventing surface part 329 from shifting greatly to the front thereof and from sliding down from the wafer inlet/outlet port 312A when things come to the worst.

When the wafer carrier 310 is put into a horizontal position, the wafer 311 is automatically loaded or unloaded by the robot. The rib pieces 315A are formed in such way that the distance between adjacent rib pieces is long. Thus, the wafer 311 does not touch the rib pieces 315A. Consequently, the loading and unloading of the wafer 311 can be facilitated.

The wafer 311 loaded by the robot is supported at four points on the thin-plate supporting portions 327 and the inner-part portions 322 and 322 under a condition in which the safer 311 is inserted into the wafer carrier 310.

In each of the thin-plate supporting portions 327, the lower side surface of the edge portion of the wafer 311 is placed on the horizontally-supporting-plate part 328 under a situation in which the edge portion of the wafer 311 is put into abutting engagement with or is placed at a small distance from the wall surface 329A of the shift preventing surface part 329.

The wafer carrier 310 put into this state is sometimes transported. Moreover, at that time, a shock such as a vibration is often applied to the wafer carrier 310. In such a case, the wafer 311 contained in the carrier 310 is liable to slip from the four points (namely, the thin-plate supporting portions 327 and the inner-part portions 322). That is, the wafer 311 is liable to shift to the front or rear of the wafer carrier (namely, in the direction of the longitudinal direction of the rib piece 315A) and to the lateral direction thereof. The front portion of this wafer 311 is, however, supported by the shift preventing surface part 329 formed like an arc In such a way as to surround the peripheral edge of the wafer 311 during the back portion of the wafer 311 is supported by the inner-part portions 322 formed in such a manner as to be bent inwardly. Thus, although the wafer 311 is shifted to and from slightly, the wafer 311 is supported and maintained on the four points.

Thereby, the wafer 311 contained in the carrier 310 is hardly shifted even when a shock such as a vibration is given from the outside to the carrier 310. Thus, the wafer 311 can be supported securely. Consequently, the wafer 311 is reliably prevented from shifting greatly to the wafer inlet/outlet port 312A and from sliding down therefrom when things come to the worst.

Moreover, the wafer 311 is supported in the wafer carrier 310 in such a fashion that the wafer 311 is not shifted therein. Thus the robot can reliably load and unload the wafer without making contact therewith.

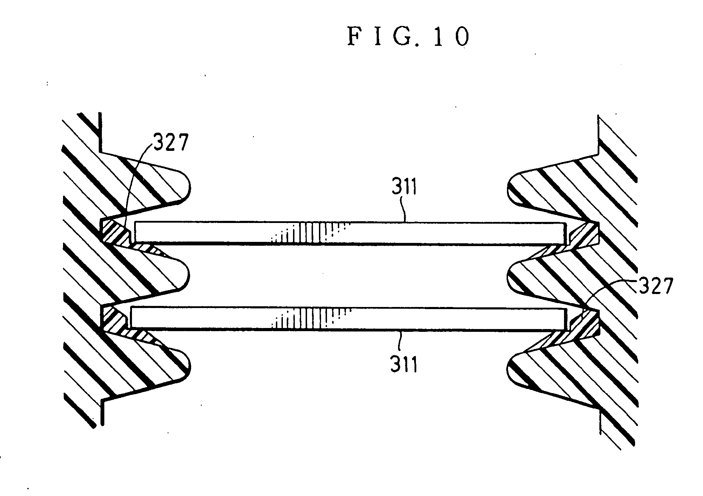

Incidentally, the thin-plate supporting portions 327 is formed like a staircase. However, as illustrated in FIG. 10, the thin-plate supporting portions 327 may be formed in such a way that the section thereof has a sloped shape, namely, is shaped like a wedge and that the horizontally-supporting-plate part 328 and the shift preventing surface part 329 are formed on this sloped surface thereof

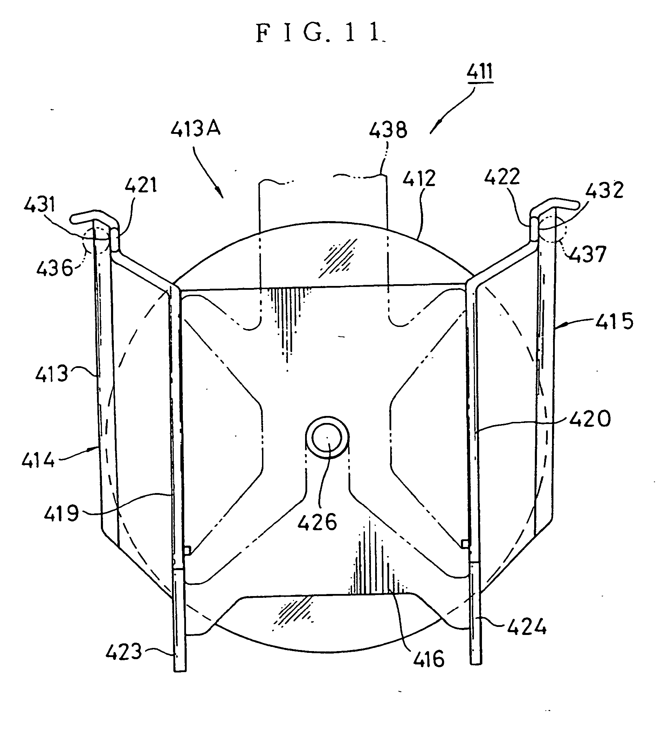

A semiconductor wafer carrier 411 described below contains and supports large-diameter a semiconductor wafer 412. The entire configuration of the semiconductor wafer carrier 411 is almost similar to that of the first mentioned semiconductor wafer carrier 110. Practically, as illustrated in FIG. 11, the semiconductor wafer carrier 411 consists of a casing 413, whose top is opened so as to form a wafer inlet/outlet port 413A, through which a wafer 412 is loaded thereinto and is unloaded therefrom, and supporting rib portions (not shown) which are respectively formed on the inner side walls of the casing 413 and are operative to hold and support a multitude of wafers 412 in parallel on multiple stages.

This casing 413 consists of both of the side walls 414 and 415, which are provided with the supporting ribs on the inner surfaces thereof and cover the outer peripheral edge surface of the semiconductor wafer 412 contained and supported therein, and front and rear end walls (incidentally, only the front end wall 416 is shown in this figure for simplicity of drawing) for connecting the front and rear surfaces of the semiconductor wafer 412.

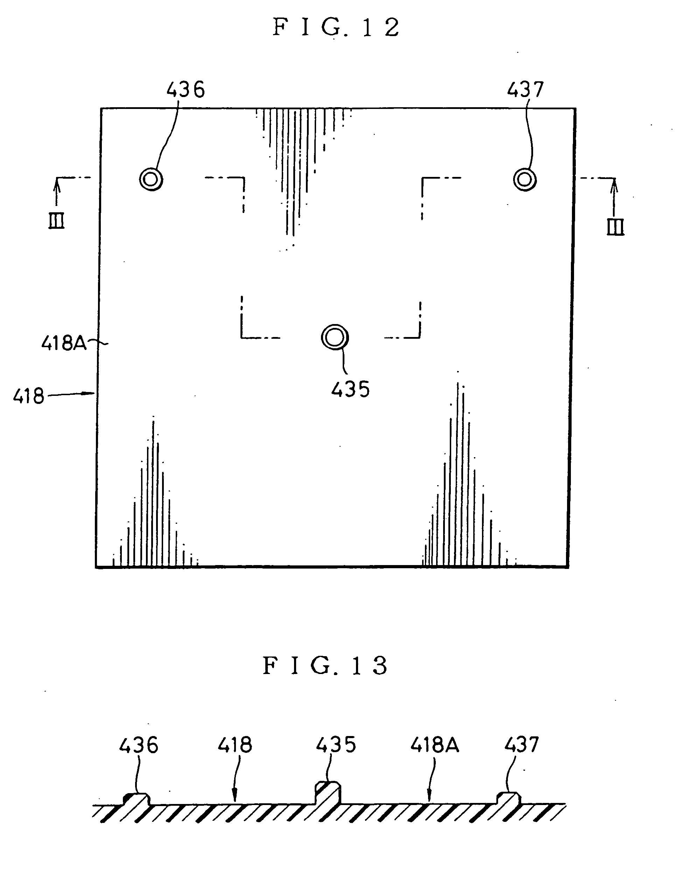

On the front end wall 416, there are provided horizontally-supporting-plate parts 419 and 420 for supporting the casing 413 accurately in a horizontal position when placing the casing 413 on a mounting base 418 (see FIG. 12) in such a manner that the longitudinal side thereof extends vertically (namely, in such a manner as to be in a state in which the inserted semiconductor wafer 412 is supported in a horizontal position). These horizontally-supporting-plate parts 419 and 420 support the inserted semiconductor wafer 412 accurately in a horizontal position by precisely supporting the casing 413 in a horizontal position. Further, the horizontally-supporting-plate parts 419 and 420 are provided as a pair of left-side and right-side components and extend throughout the length of the casing vertically, as viewed in FIG. 11. Moreover, on the top and bottom end portions of the horizontally-supporting-plate parts 419 and 420, there are respectively provide horizontally-supporting projections 421, 422, 423 and 424 which are directly put into abutting engagement with an upper side surface 418A of the mounting base 418.

Furthermore, a positioning concave portion 426 serving as the fitting portion for positioning the casing 413 is provided on the front end wall 416. This positioning concave portion 426 is positioned at a position, which corresponds to the center of the semiconductor wafer 412 contained in the casing 413, on the front end wall 416. This positioning of the concave portion 426 is performed in order to indirectly position the contained semiconductor wafer 412 at a particular place by directly positioning the concave portion 426 at a specific place.

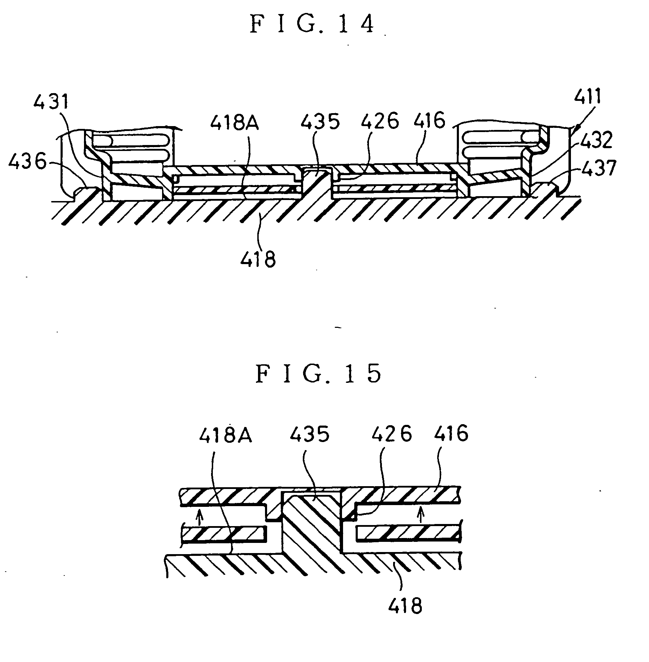

As illustrated in FIG. 15, the positioning concave portion 426 is formed like a shallow or short cylinder. The innermost part of the concave portion 426 (namely, the top end portion thereof as viewed in this figure) is covered or blocked. This is accomplished in order that even if dusts or the like are produced owing to the friction between the positioning concave portion 426 and a positioning pin 435, the dusts or the like are prevented from being mixed into the casing 413. The inner peripheral edge of the wall surrounding the bottom end opening of the positioning concave portion 426 is chamfered, namely, tapered, so that the positioning pin 435 (to be described later) can be inserted thereinto smoothly. The depth of the positioning concave portion 426 is set at a value which is small to the extent that when the casing 413 is placed on the upper side surface 418A of the mounting base 418 and the positioning concave portion 426 is fit onto the positioning pin 435, the tip portion (namely, the top end portion) of the positioning pin 435 does not touch the innermost part of the positioning concave portion 426. This is because of the fact that when the tip portion of the positioning pin 435 touches the innermost part of the positioning concave portion 426, consequently, the casing 413 is thrust up by the positioning pin 435, and the front end wall 416 becomes deformed and an error in performing the vertical positioning of the wafer 412 is caused.

Outer parts of the horizontally-supporting-plate portion 419 and 420 corresponding to the horizontally-supporting projections 421 and 422 are formed in such a way that accurate dimensions are obtained. These parts act as the rotation prevention fitting portions 431 and 432. These rotation prevention fitting portions 431 and 432 are brought into abutting engagement with and are supported by the rotation preventing pins 436 and 437 (to be described) of the mounting base 418, respectively. Thus, the rotation prevention fitting portions 431 and 432 prevent the casing 413 from rotating around the positioning concave portion 426. Moreover, the opening port 413A is accurately directed to the direction of a hand 438 of the robot, so that the direction of rotation is determined.

As illustrated in FIGS. 12 and 13, the mounting base 418 has the upper side surface 418A which is a horizontally flat surface and is finished with high accuracy. The positioning pin 435 serving as the fit portion, to which the positioning concave portion 426 of the front end wall 416 is fit, is provided on the central portion of this upper side surface 418A. The top peripheral edge of the positioning pin 435 is chamfered, namely, tapered, so that the positioning pin 435 can be smoothly fit into the positioning concave portion 426. Further, the rotation preventing pins 436 and 437 are provided at places which correspond to the rotation prevention fitting portions 431 and 432 of the casing 413, respectively, when the positioning concave portion 426 is fit onto the positioning pin 435.

The wafer carrier 411 having the aforementioned configuration is positioned on the mounting base 418 and the semiconductor wafer 412 is automatically loaded and unloaded in the following manner.

A plurality of semiconductor wafers 412 are inserted and supported on multiple stages in parallel in the wafer carrier 411. This wafer carrier 411 is placed on the mounting base 418. Practically, when the horizontally supporting projections 421, 422, 423 and 424 of the horizontally-supporting-plate parts 419 and 420 are directly brought into abutting engagement with the upper side surface 418A of the mounting base 418 and the vertical positioning thereof is accomplished, the wafer carrier 411 is placed on the mounting base 418. Further, at that time, the positioning concave portion 426 of the front end wall 416 is fit onto the mounting-base-side positioning pin 435. Moreover, the rotation prevention fitting portions 431 and 432 are fit onto the area between the rotation preventing pins 436 and 437. The horizontal positioning (namely, the lateral positioning) of the casing 413 is performed by fitting the positioning concave portion 426 onto the positioning pin 435. Furthermore, the positioning of the wafer 412 in the direction of rotation of the opening port 413A is performed by fitting the rotation prevention fitting portions 431 and 432 onto the rotation preventing pins 436 and 437, respectively.

Thereby, the supporting ribs of the casing 413 and the semiconductor wafers 412 supported by the supporting ribs are accurately positioned with respect to the hand 438 of the robot. When the casing 413 is in this state, the robot inserts the hand 438 into a space between the adjacent semiconductor wafers 412 accurately and lifts the semiconductor wafer slightly. Then, this wafer 412 is unloaded therefrom. Further, the semiconductor wafer 412 supported by the hand 438 is accurately inserted into a space between adjoining ones of the multitude of supporting ribs and then the hand 438 is lowered slightly. Thereafter, during the casing 413 is in a state in which the semiconductor 412 is supported by the supporting rib, this semiconductor wafer 412 is pulled out of the casing 413 without touching another semiconductor wafer 412. At that time, the positioning thereof in the direction of rotation is performed by means of the rotation prevention fitting portions 431 and 432 and the rotation preventing pins 436 and 437. Thus the hand 438 of the robot can be smoothly put into and out of the casing 413 without touching the side walls 414 and 415 of the casing 413.

As above stated, in the case of the aforesaid semiconductor wafer carrier 411, if the size of the wafer carrier 411 increases as the diameter of the semiconductor wafer 412 is upsized, the horizontal positioning of the semiconductor wafer 412 can be achieved easily and accurately by utilizing the positioning concave portion 426. Thereby, the horizontal positioning of the semiconductor wafer 412, whose center is placed in the positioning concave portion 426, can be performed accurately. At that time, there is a gap between the innermost part of the positioning concave portion 426 and the upper end portion of the positioning pin 435. Thus, no ill influence is exerted upon the vertical positioning of the wafer 412. Consequently, the vertical positioning of the wafer 412 is accurately achieved by utilizing only the horizontally supporting projections 421, 422, 423 and 424.

Moreover, the positioning of the wafer 412 in the direction of rotation can be performed easily and accurately by utilizing the rotation prevention fitting portions 431 and 432. Thus, the opening port 413A of the casing 413 can be accurately directed to the hand 438 of the robot.

As a consequence, the hand 438 of the robot can be prevented reliably from touching the semiconductor wafer 412 and the casing 413. Thereby, an occurrence of damage to the surface of the semiconductor wafer 412 and the generation of dusts can be prevented.

In the aforesaid thin-plate supporting container, the positioning concave portion 426 is provided on the front end wall 416. The positioning concave portion 426, however, may be provided on the rear end wall (not shown). Further, the positioning concave portions may be provided on both of the front and rear end walls.

Moreover, in the aforementioned thin-plate supporting container, the fitting portion for positioning is constituted by the positioning concave portion 426. The fitting portion for positioning, however, may be constituted by a fitting projection such as the positioning pin 435.

Furthermore, in the aforesaid thin-plate supporting container, the rotation prevention fitting portions 431 and 432 are constituted by the outer surface portions of the horizontally supporting projections 421 and 422. The rotation prevention fitting portions 431 and 432, however, may be constituted by a fitting concave portion, a fitting projection, an elongated groove or a ridge. The elements of each of these sets are fit to each other. Thus, the rotation of the casing can be prevented by providing only one set of such elements therein. Needless to say, two sets or more of such elements may be provided in the casing.

When one of the rotation prevention fitting portions is constituted by a fitting concave portion, a fitting projection is provided on the upper side surface 418A of the mounting base 418. Similarly, when one of the rotation prevention fitting portions is constituted by a fitting projection, a fitting concave portion is provided in the upper side surface 418A of the mounting base 418. Further, when one of the rotation prevention fitting portions is constituted by an elongated groove, the elongated groove is formed in, for example, each of the horizontally-supporting-plate parts 419 and 420. Moreover, at that time, a ridge to be fit into the elongated groove is formed on the upper side surface 418A of the mounting base 418. Similarly, when one of the rotation fitting portions is constituted by a ridge, the ridge is formed on, for example, each of the horizontally-supporting-plate parts 419 and 420. Furthermore, at that time, an elongated groove to be fit onto the ridge is provided on the upper side surface 418A of the mounting base 418.

Additionally, in the aforementioned thin-plate supporting container, the rotation prevention fitting portions 4331 and 432 are provided on the outer sides of the horizontally supporting projections 421 and 422, respectively. It is preferable that the rotation prevention fitting portions 431 and 432 are provided at the furthest possible places from the positioning concave portion 426 in the front-end-wall-side of the casing 413. This is because of the fact that as the location of the rotation prevention fitting portion becomes farther from the positioning concave portion 426, a change in angle in the direction of rotation is amplified and thereby, an error in positioning in the direction of rotation can be limited to a small value.

As above described in detail, in the case of the thin-plate supporting container, a thin plate can be supported accurately in a horizontal position. The thin plate can be prevented from touching another thin plate, the container, the fork of the robot and so forth when loaded or unloaded.

## Claims

1. A thin-plate supporting container comprising:
a casing (312) having side walls (313, 314);
supporting rib portions (315), each of which consists of multiple rib pieces (315A), for supporting thin plates (311) respectively on multiple stages at regular intervals, the supporting rib portions (315) being provided on each of the side walls (313, 314) of the container in parallel in such a way that each of the supporting rib portions (315) provided on one (313) of the side walls and a corresponding each of the supporting rib portions (315) provided on the other (314) of the side walls face each other and sandwich the thin plate (311) when supported in the container; and
an opening portion serving as an inlet/outlet port (312A), through which the thin plate (311) is loaded or unloaded from the container, wherein each of the rib pieces (315A) has a thin-plate supporting portion (327),
**characterized in that** the thin-plate supporting portion (327) is provided on one of the outer surfaces of each of the rib pieces (315A) and comprises a horizontally-supporting-part (328) and a shift preventing surface part (329), the horizontally-supporting-portion (328) having a supporting surface which extends horizontally so as to be able to support a thin plate horizontally when the container is oriented such that the rib portions extend horizontally, and the shift preventing surface part (329) comprising a wall surface (329A) formed in the form of an arc conformal in shape to a peripheral edge of a thin plate (311) for coming into abutting engagement with the periphery edge of a thin plate (311) supported by the horizontally-supporting-part so as to prevent the thin plate from shifting toward the inlet/outlet port.

2. A thin-plate supporting container according to claim 1, **characterized in that** the opposing outer surfaces of each respective rib piece (315A) are inclined towards each other towards an apex which is rounded so that the cross-sectional shape of the rib pieces is nearly V-shaped with a rounded apex.

3. A thin-plate supporting container according to claim 1 or 2, **characterized in that** the thin-plate supporting portions (327) are provided such as to be on the upper outer surface of each of the rib pieces when the container is oriented such that the rib pieces extend horizontally.

## Patentansprüche

1. Lagerbehälter für dünne Platten, aufweisend:
ein Gehäuse (312), der Seitenwände hat (313, 314);
Lagerungsrippenabschnitte (315), von denen jeder aus mehreren Rippenstücken (315A) besteht, um jeweils die dünnen Platten (311) in mehreren Stufen in gleichmäßigen Abständen zu lagern, wobei die Lagerungsrippenabschnitte (315) an jede der Seitenwände (313, 314) des Behälter parallel in solch einer Weise vorgesehen sind, dass jeder der Lagerungsrippenabschnitte (315), vorgesehen an einer (313) der Seitenwände und ein entsprechender jeder der Lagerungsrippenabschnitte (315), vorgesehen an der anderen (314) der Seitenwände, einander zugewandt sind, um die dünne Platte (311) dazwischen aufzunehmen, wenn sie in dem Behälter gelagert wird, und
einen Öffnungsabschnitt, der als eine Einlass- / Auslass- Öffnung (112A) dient, durch die eine dünne Platte (311) in diesen Behälter hineingeladen oder aus diesem entnommen wird, wobei jedes der Rippenstücke (315A) einen Lagerungsabschnitt für eine dünne Platte (327) hat, **dadurch gekennzeichnet, dass** der Lagerungsrippenabschnitt für eine dünne Platte (327) vorgesehen ist an einer der Außenoberflächen jeder der Rippenstücke (315A) und aufweist ein horizontal- lagerndes Teil (328) und einen Verschiebungsverhinderungs- Oberflächenteil (329), wobei der horizontal- lagernde Abschnitt (328) eine Lagerungsoberfläche hat, die sich horizontal erstreckt, um in der Lage zu sein, die dünne Platte horizontal zu lagern, wenn der Behälter derart ausgerichtet ist, dass sich die Rippenabschnitte horizontal erstrecken und das Verschiebungsverhinderungs- Oberflächenteil (329) eine Wandoberfläche (329A) aufweist, gebildet in der Form Bogens, in der Form angepasst an eine Umfangskante einer dünnen Platte (311), um in Anlageeingriff mit der Umfangskante (311), gelagert durch das horizontal- lagernde Teil zu kommen, um die dünne Platte am Verschieben in die Richtung zu der Einlass- /Auslassöffnung zu hindern.

2. Lagerbehälter für dünne Platten nach Anspruch 1, **dadurch gekennzeichnet, dass** die gegenüberliegenden Oberflächen von jedem des jeweiligen Rippenstücks (315A) in die Richtung zueinander in die Richtung zu einem Scheitelpunkt, der gerundet ist, geneigt sind, so dass die Querschnittsform der Rippenstücke nahezu V- förmig mit einem abgerundeten Scheitelpunkt ist.

3. Lagerbehälter für dünne Platten nach Anspruch 1 oder 2, **dadurch gekennzeichnet, dass** die Lagerungsrippenabschnitte für eine dünne Platte (327) vorgesehen sind, um auf der Außenoberfläche jedes der Rippenstücke zu sein, wenn der Behälter derart ausgerichtet ist, dass sich die Rippenstücke horizontal erstrecken.

## Revendications

1. Conteneur de support de plaques fines, comprenant :
un boîtier (312) ayant des parois latérales (313, 314) ;
des parties de nervures de support (315), dont chacune consiste en de multiples pièces de nervures (315A), destinées à supporter des plaques fines (311) respectivement sur plusieurs étages à intervalles réguliers, les parties de nervures de support (315) étant positionnées sur chacune des parois latérales (313, 314) du conteneur de manière parallèle, de telle sorte que chacune des parties de nervures de support (315) apportée sur l'une (313) parmi les parois latérales et chacune des parties de nervures de support (315) correspondante apportée sur l'autre (314) parmi les parois latérales soient l'une en face de l'autre et intercalent la plaque fine (311) lorsqu'elle est supportée dans le conteneur, et
une partie formant ouverture servant d'orifice d'entrée/de sortie (312A), à travers lequel la plaque fine (311) est chargée ou déchargée depuis le conteneur, dans lequel chacune parmi les pièces de nervures (315A) possède une partie de support de plaque fine (327),
**caractérisé en ce que** la partie de support de plaque fine (327) est apportée sur l'une des surfaces externes de chacune des pièces de nervures (315A) et comprend une partie de support horizontal (328) et une partie de surface de prévention des déplacements (329), la partie de support horizontal (328) possédant une surface de support qui s'étend horizontalement de façon à pouvoir supporter une plaque fine de manière horizontale lorsque le conteneur est orienté de telle sorte que les parties de nervures s'étendent horizontalement, et la partie de surface de prévention des déplacements (329) comprenant une surface de paroi (329A) construite en forme d'arc dont la forme est conforme au bord périphérique d'une plaque fine (311) de manière à venir en butée avec le bord périphérique d'une plaque fine (311) supportée par la partie de support horizontal afin d'empêcher la plaque fine de se déplacer vers l'orifice d'entrée/ de sortie.

2. Conteneur de support de plaques fines selon la revendication 1, **caractérisé en ce que** les surfaces externes opposées de chaque pièce de nervures respective (315A) sont inclinées les unes par rapport aux autres dans le sens d'un sommet qui est arrondi de telle sorte que la forme de la coupe transversale des pièces de nervures soit sensiblement en forme de V avec un sommet arrondi.

3. Conteneur de support de plaques fines selon la revendication 1 ou 2, **caractérisé en ce que** les parties de support de plaques fines (327) sont apportées de façon à se trouver sur la surface externe supérieure de chacune des pièces de nervures lorsque le conteneur est orienté de telle sorte que les pièces de nervures s'étendent horizontalement.
